# EUROPEAN PATENT SPECIFICATION

(11) **EP 3 012 568 B1**
(45) Date of publication and mention of the grant of the patent: **12.09.2018**
(21) Application number: 14189488.1
(22) Date of filing: 20.10.2014
(51) Int. Cl.: F28D 15/00, F28D 15/02, F28F 17/00, H05K 7/20, F28D 1/04, F24F 12/00, F24F 13/22

(54) **Cooling device and cooled electrical assembly comprising the same**
Kühlungsvorrichtung und gekühlte elektrische Anordnung damit
Dispositif de refroidissement et ensemble électrique refroidi le comprenant

(43) Date of publication of application: 27.04.2016
(73) Proprietor: ABB Schweiz AG, 5400 Baden (CH)
(72) Inventor: Manninen, Jorma, 00380 Helsinki (FI); Koivuluoma, Timo, 00380 Helsinki (FI)
(74) Representative: Kolster Oy Ab

(56) References cited:
- EP-A1- 2 762 810
- WO-A1-2009/022778
- DE-A1- 3 405 584
- JP-A- H04 267 593
- US-A- 4 586 342
- US-A- 5 806 583
- US-A- 6 026 891
- US-A1- 2012 174 599
- US-B1- 6 250 083

## Description

### FIELD OF THE INVENTION

The present invention relates to a cooling device and cooled electrical assembly comprising the cooling device.

An electric cabinet comprising one or more electrical apparatuses typically requires cooling. Providing an appropriate cooling may be difficult for example in situations where new apparatuses are mounted into an electric cabinet which was already nearly full. It may be necessary to reorganize the electric cabinet in order to provide required cooling for all the apparatuses. Examples of known cooling devices are described in publications US 5806583, US 6 026 891 and DE 3405584. EP 2 762 810 further discloses such an electric cabinet with two chambers and a heat exchanger and in addition a thermoelectric cooling element for condensing moisture.

### BRIEF DESCRIPTION OF THE INVENTION

An object of the present invention is to provide a cooling device and cooled electrical assembly comprising the cooling device so as to alleviate the above mentioned problem. The objects of the invention are achieved by a cooling device and cooled electrical assembly which are characterized by what is stated in the independent claim. The preferred embodiments of the invention are disclosed in the dependent claims.

The invention is based on the idea of providing a cooling device with a first chamber with an inlet flow opening and an outlet flow opening on the same side of the first chamber, a second chamber separated from the first chamber, heat exchanger means adapted to transfer heat from the first chamber to the second chamber, and fan means for generating a cooling medium flow inside the first chamber between the inlet flow opening and the outlet flow opening such that heat is transferred from the cooling medium into the heat exchanger means. A cooling device according to the invention further comprises a thermoelectric cooling element adapted to condense moisture from the first chamber, the heat exchanger means comprises a first heat exchanger, one of the sides of the thermoelectric cooling element being in heat transfer connection with a first end of the first heat exchanger.

The cooling device of the invention is easy to clean and maintain, and enables isolating a device chamber containing an electrical apparatus from ambient air such that the device chamber is adapted to exchange cooling medium exclusively with the cooling device. In an embodiment a cooling device according to present invention is adapted to be retrofitted on a wall of an existing electric cabinet.

### BRIEF DESCRIPTION OF THE DRAWINGS

In the following the invention will be described in greater detail by means of preferred embodiments with reference to the attached drawings, in which
Figure 1 shows a cooling device according to an embodiment of the invention;
Figures 2A - 2C show three alternatives for connecting a thermoelectric cooling element to heat exchanger means of a cooling device; and
Figure 3 shows a cooled electrical assembly comprising the cooling device of Figure 1.

### DETAILED DESCRIPTION OF THE INVENTION

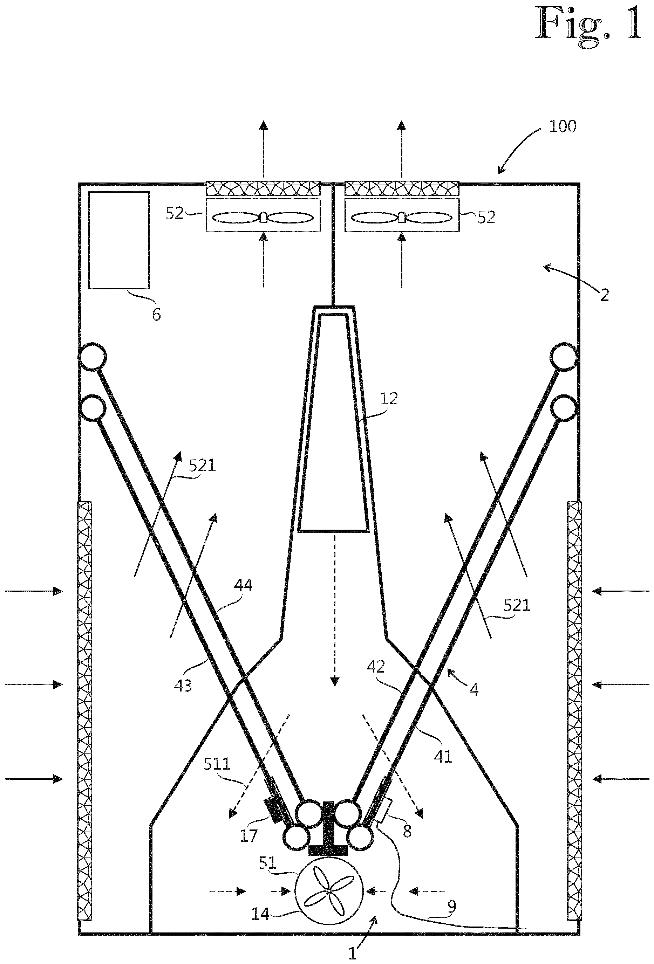

Figure 1 shows a cooling device 100 comprising a first chamber 1, a second chamber 2, heat exchanger means 4, fan means, control means 6, a thermoelectric cooling element 8, pipe means 9 and a heating element 17. The second chamber 2 is separated from the first chamber 1 and adapted to be in contact with ambient air. Separation of the first chamber 1 and second chamber 2 prevents dirt from entering the first chamber 1 from the second chamber 2. The heat exchanger means 4 comprises a first heat exchanger 41, a second heat exchanger 42, a third heat exchanger 43 and a fourth heat exchanger 44. A first end of each of the four heat exchangers is located in the first chamber 1, and a second end of each of the four heat exchangers is located in the second chamber 2. The heat exchanger means 4 is adapted to transfer heat from the first chamber 1 to the second chamber 2.

Each of the four heat exchangers 41 to 44 is a compact thermosyphon heat exchanger. A compact thermosyphon heat exchanger is a passive heat exchanger based on natural convection. Said first end of each of the four heat exchangers is a lower end thereof, and said second end of each of the four heat exchangers is an upper end thereof. In an alternative embodiment heat exchanger means comprises at least one heat exchanger. Said at least one heat exchanger may comprise a compact thermosyphon heat exchanger and/or a heat exchanger of another type.

Each heat exchanger 41 to 44 is in an inclined position extending in an angle of inclination relative to horizontal direction. In the embodiment of Figure 1 the angle of inclination is approximately 65°. In an alternative embodiment including one or more compact thermosyphon heat exchangers the angle of inclination may be between 35° and 90°. In an embodiment including a heat exchanger which is not a compact thermosyphon heat exchanger the heat exchanger may extend at any angle especially if the heat exchanger is based on a forced cooling medium flow inside the heat exchanger. In a further embodiment heat exchanger means comprises at least one curved heat exchanger. Using curved heat exchangers allows more freedom in cooling device design.

The heat exchanger means 4 divides the first chamber 1 into an upper section and a lower section. To be more specific, the first ends of the heat exchangers 41 to 44 divide the first chamber 1 into an upper section and a lower section. The first chamber 1 comprises an inlet flow opening 12 in the upper section of the first chamber 1, and an outlet flow opening 14 in the lower section of the first chamber 1. Inside the first chamber 1 the only route for a cooling medium flow from the inlet flow opening 12 to the outlet flow opening 14 passes through the first ends of the heat exchangers 41 to 44. Besides the inlet flow opening 12 and the outlet flow opening 14 there are no openings in the first chamber 1 providing access between an interior and an exterior of the first chamber 1.

The inlet flow opening 12 and the outlet flow opening 14 are located on the same side of the first chamber 1 on a connection wall of the cooling device 100. The cooling device 100 is adapted to be connected to a device chamber containing a heat generating apparatus such that the connection wall of the cooling device 100 faces the device chamber. In an alternative embodiment inlet flow opening and outlet flow opening are located on different sides of a first chamber. Such a design is useful when an electric cabinet comprising a device chamber has a stepped profile.

The fan means comprises a first fan 51 and two second fans 52. The control means 6 is adapted to control the fan means in order to adjust cooling power of the cooling device. The control means 6 is also adapted to control the thermoelectric cooling element 8 and the heating element 17. The control means 6 is adapted to receive measurement data from one or more humidity sensors and one or more temperature sensors which are not depicted in Figure 1.

In an alternative embodiment control means comprises at least one thermostat adapted to control fan means based on temperature present in a first chamber of cooling device. In a further alternative embodiment a cooling device does not comprise control means. Such a simple embodiment is feasible in steady environments, for example when a cooling device is located indoors.

The first fan 51 is adapted to generate a first cooling medium flow 511 inside the first chamber 1 between the inlet flow opening 12 and the outlet flow opening 14 through the first ends of the heat exchangers 41 to 44. The first fan 51 is located in the first chamber 1. In an alternative embodiment fan means comprises a plurality of first fans adapted to generate a first cooling medium flow inside the first chamber between the inlet flow opening and the outlet flow opening through first end of at least one heat exchanger.

The second chamber 2 comprises two sub chambers separated from each other. Each of the sub chambers is divided into an upper section and a lower section by the heat exchanger means 4. One of the sub chambers is divided into an upper section and a lower section by the second ends of the heat exchangers 41 and 42. The other sub chamber is divided into an upper section and a lower section by the second ends of the heat exchangers 43 and 44.

Each sub chamber of the second chamber 2 comprises a second fan 52 adapted to generate a second cooling medium flow 521 through the second ends of corresponding heat exchangers. One second fan 52 is adapted to generate a second cooling medium flow 521 through the second ends of the heat exchangers 41 and 42. Another second fan 52 is adapted to generate a second cooling medium flow 521 through the second ends of the heat exchangers 43 and 44.

Each second cooling medium flow 521 enters a lower section of corresponding sub chamber through an inlet filter, passes through the second ends of corresponding heat exchangers, and exits the sub chamber through an outlet filter. The inlet filter and the outlet filter are adapted to keep the second chamber clean thereby maintaining cooling power of the heat exchangers. In an embodiment inlet filter and the outlet filter are coarse filters.

Operation of each sub chamber of the second chamber 2 is independent from operation of the other sub chamber. Malfunction of one second fan 52 decreases cooling power of the cooling device less than 50% because the other second fan 52 still operates with full power and there is natural convection present in the sub chamber with the malfunctioning fan. This also means that during maintenance it is possible to turn of the second fans one at the time while the other is operating. After one second fan is turned off a sub chamber containing the one second fan may be cleaned. Cleaning a sub chamber may include cleaning each second end of heat exchanger located in the sub chamber.

Then the one second fan is restarted and the other second fan is turned off for cleaning procedure. Consequently the cooling device provides at least 50 % cooling power even during cleaning of the second chamber 2.

In an alternative embodiment a second chamber does not comprise any second fans. In such an alternative embodiment a natural convection provides a cooling medium flow in the second chamber. It is also possible to provide the second chamber as an undivided chamber. In a further alternative embodiment a second chamber is an open chamber with less walls than depicted in Figure 1. In an embodiment where an environment of the cooling device is clean the second chamber does not need any walls except a wall separating the second chamber from the first chamber.

The thermoelectric cooling element 8 is located in the lower section of the first chamber 1. The thermoelectric cooling element 8 is in heat transfer connection with a first end of the first heat exchanger 41. The thermoelectric cooling element 8 is adapted to condense moisture from the first chamber 1. The pipe means 9 is adapted to carry water condensed by the thermoelectric cooling element 8 into the second chamber 2. In an alternative embodiment pipe means is adapted to carry water condensed by the thermoelectric cooling element out of the first chamber. The condensed water may be led out of the cooling device. In a further alternative embodiment pipe means may be omitted.

The heating element 17 is adapted to heat the first chamber 1. The heating element 17 is in heat transfer connection with a first end of the third heat exchanger 43. In an alternative embodiment a cooling device does not comprise a heating element. A heating element may be omitted for example in embodiments where temperature is always above freezing point.

A heat transfer connection between a heating element and a first end of a heat exchanger transfers heat of the heating element effectively to a bypassing cooling medium flow. A heating element may comprise a resistor.

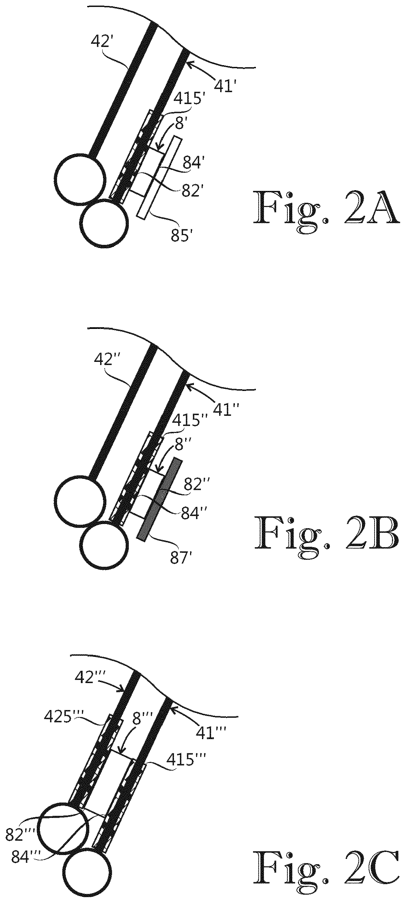

Figures 2A - 2C show three alternatives for connecting a thermoelectric cooling element to heat exchanger means of a cooling device. Figure 2A shows a thermoelectric cooling element 8' having a hot side 82' and a cold side 84'. The hot side 82' is in heat transfer connection with a first end of a first heat exchanger 41'. The first end of the first heat exchanger 41' is provided with a base plate 415', and the hot side 82' of the thermoelectric cooling element 8' is in heat transfer connection with the base plate 415'. The base plate 415' is adapted to increase contact area between the first end of the first heat exchanger 41' and the hot side 82' of the thermoelectric cooling element 8'. There is a water condensation plate 85' connected to the cold side 84' of the thermoelectric cooling element 8'. During operation of the cooling element 8' water condenses on a surface of the water condensation plate 85'. The thermoelectric cooling element 8' is positioned on an underside of the inclined cooling element 8' such that water dripping from the water condensation plate 85' does not drip on the first heat exchanger 41' or on a second heat exchanger 42' located on opposite side of the first heat exchanger 41' relative to the thermoelectric cooling element 8'.

Figure 2B shows a thermoelectric cooling element 8" whose cold side 84" is in heat transfer connection with a base plate 415" of a first heat exchanger 41". There is a heat sink 87" connected to the hot side 82" of the thermoelectric cooling element 8".

Figure 2C shows heat exchanger means comprising a first heat exchanger 41'" and a second heat exchanger 42'" adjacent the first heat exchanger 41'". There is a thermoelectric cooling element 8'" between the first heat exchanger 41'" and the second heat exchanger 42"'. A cold side 84'" of the thermoelectric cooling element 8'" is in heat transfer connection with a base plate 415'" of the first heat exchanger 41"'. A hot side 82'" of the thermoelectric cooling element 8'" is in heat transfer connection with a base plate 425'" of the second heat exchanger 42"'.

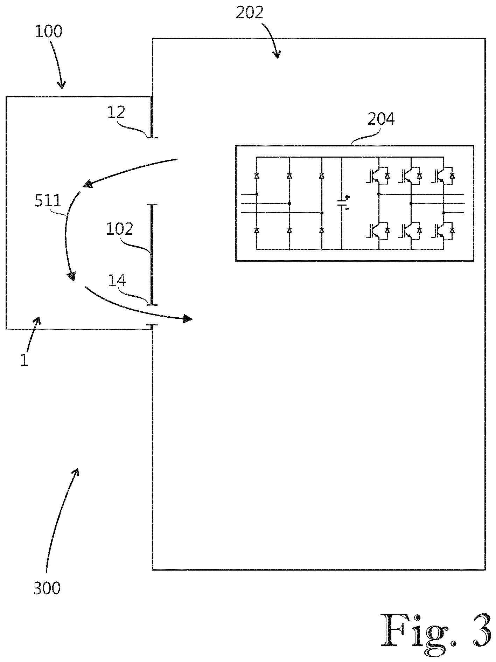

Figure 3 shows a cooled electrical assembly 300 comprising the cooling device 100 of Figure 1. The cooling device 100 is connected to a device chamber 202 containing a heat generating apparatus 204. A connection wall 102 of the cooling device 100 faces the device chamber 202. The connection wall 102 is a substantially planar wall for facilitating connection of the cooling device 100 to the device chamber 202. In an embodiment the heat generating apparatus comprises a frequency converter. In an alternative embodiment the heat generating apparatus comprises an inverter or some other electrical apparatus which requires cooling.

The device chamber 202 is isolated from ambient air such that the device chamber 202 is adapted to exchange cooling medium exclusively with the first chamber 1 of the cooling device 100. Therefore cooling medium circulating in the device chamber 202 is always clean.

It will be obvious to a person skilled in the art that the inventive concept can be implemented in various ways. The invention and its embodiments are not limited to the examples described above but may vary within the scope of the claims.

## Claims

1. A cooling device comprising:
a first chamber (1);
a second chamber (2) separated from the first chamber (1) and adapted to be in contact with ambient air;
heat exchanger means (4) comprising at least one heat exchanger, the heat exchanger means (4) dividing the first chamber (1) into an upper section and a lower section, a first end of each of the at least one heat exchanger being located in the first chamber (1), and a second end of each of the at least one heat exchanger being located in the second chamber (2), the heat exchanger means (4) being adapted to transfer heat from the first chamber (1) to the second chamber (2); and
fan means;
the first chamber (1) comprises an inlet flow opening (12) in the upper section of the first chamber (1), and an outlet flow opening (14) in the lower section of the first chamber (1), the fan means comprises at least one first fan (51) adapted to generate a first cooling medium flow (511) inside the first chamber (1) between the inlet flow opening (12) and the outlet flow opening (14) through the first end of the at least one heat exchanger, and the cooling device (100) is adapted to be connected to a device chamber (202) containing a heat generating apparatus (204), whereby the cooling device (100) comprises a thermoelectric cooling element (8') having a hot side (82') and a cold side (84'), the thermoelectric cooling element (8') being adapted to condense moisture from the first chamber (1),
**characterized in that** the heat exchanger means (4) comprises a first heat exchanger (41), one of the sides of the thermoelectric cooling element (8') being in heat transfer connection with a first end of the first heat exchanger (41).

2. A cooling device according to claim 1, **characterized in that** the cooling device (100) comprises pipe means (9) adapted to carry water condensed by the thermoelectric cooling element (8) out of the first chamber (1).

3. A cooling device according to claim 2, **characterized in that** the pipe means (9) is adapted to carry water condensed by the thermoelectric cooling element (8) into the second chamber (2) or out of the cooling device (100).

4. A cooling device according to any one of claims 1 to 3, **char-acterized** in that the heat exchanger means comprises a second heat exchanger (42"') adjacent the first heat exchanger (41"'), the other side of the thermoelectric cooling element (8'") being in heat transfer connection with a first end of the second heat exchanger (42'").

5. A cooling device according to any one of claims 1 to 4, **characterized in that** the cooling device (100) comprises a heating element (17) adapted to heat the first chamber (1), the heating element (17) being in heat transfer connection with a first end of at least one heat exchanger.

6. A cooling device according to any one of preceding claims, **characterized in that** the at least one heat exchanger comprises at least one compact thermosyphon heat exchanger.

7. A cooling device according to any one of preceding claims, **characterized in that** the inlet flow opening (12) and the outlet flow opening (14) are located on the same side of the first chamber (1) on a connection wall (102) of the cooling device (100) and the connection wall (102) is a substantially planar wall for facilitating connection of the cooling device (100) to the device chamber (202).

8. A cooled electrical assembly comprising a device chamber (202) containing a heat generating apparatus (204), and a cooling device (100) connected to the device chamber (202) for cooling the heat generating apparatus (204), **characterized in that** the cooling device (100) is a cooling device according to any one of claims 1 to 7.

9. A cooled electrical assembly according to claim 8, **characterized in that** the device chamber (202) is isolated from ambient air such that the device chamber (202) is adapted to exchange cooling medium exclusively with the first chamber (1) of the cooling device (100).

## Patentansprüche

1. Kühlungsvorrichtung, umfassend:
eine erste Kammer (1),
eine zweite Kammer (2), die von der ersten Kammer (1) getrennt und dazu eingerichtet ist, mit Umgebungsluft in Kontakt zu stehen;
ein Wärmetauschermittel (4), umfassend mindestens einen Wärmetauscher, wobei das Wärmetauschermittel (4) die erste Kammer (1) in einen oberen Abschnitt und einen unteren Abschnitt unterteilt, wobei sich ein erstes Ende von jedem der mindestens einen Wärmetauscher in der ersten Kammer (1) befindet, und ein zweites Ende von jedem der mindestens einen Wärmetauscher in der zweiten Kammer (2) befindet, wobei das Wärmetauschermittel (4) dazu eingerichtet ist, Wärme von der ersten Kammer (1) auf die zweite Kammer (2) zu übertragen; und
ein Lüftermittel;
wobei die erste Kammer (1) eine Einlassströmungsöffnung (12) in dem oberen Abschnitt der ersten Kammer (1) und eine Auslassströmungsöffnung (14) in dem unteren Abschnitt der ersten Kammer (1) umfasst, wobei das Lüftermittel mindestens einen ersten Lüfter (51) umfasst, der dazu eingerichtet ist, einen ersten Kühlmittelstrom (511) in der ersten Kammer (1) zwischen der Einlassströmungsöffnung (12) und der Auslassströmungsöffnung (14) durch das Ende des mindestens einen Wärmetauschers zu erzeugen, und wobei die Kühlungsvorrichtung (100) dazu eingerichtet ist, mit einer Vorrichtungskammer (202) verbunden zu werden, die eine wärmeerzeugende Vorrichtung (204) enthält,
wobei die Kühlungsvorrichtung (100) ein thermoelektrisches Kühlungselement (8') mit einer warmen Seite (82') und einer kalten Seite (84') aufweist, wobei das thermoelektrische Kühlungselement (8') dazu eingerichtet ist, Feuchtigkeit aus der ersten Kammer (1) zu kondensieren,
**dadurch gekennzeichnet, dass**
das Wärmetauschermittel (4) einen ersten Wärmetauscher (41) umfasst, wobei eine der Seiten des thermoelektrischen Kühlungselements (8') in Wärmeübertragungsverbindung mit einem ersten Ende des ersten Wärmetauschers (41) steht.

2. Kühlungsvorrichtung nach Anspruch 1, **dadurch gekennzeichnet, dass** die Kühlungsvorrichtung (100) ein Rohrmittel (9) umfasst, das dazu eingerichtet ist, Wasser, das von dem thermoelektrischen Kühlungselement (8) kondensiert wird, aus der ersten Kammer (1) zu führen.

3. Kühlungsvorrichtung nach Anspruch 2, **dadurch gekennzeichnet, dass** das Rohrmittel (9) dazu eingerichtet ist, Wasser, das von dem thermoelektrischen Kühlungselement (8) kondensiert wird, in die zweite Kammer (2) oder aus der Kühlungsvorrichtung (100) zu führen.

4. Kühlungsvorrichtung nach einem der Ansprüche 1 bis 3, **dadurch gekennzeichnet, dass** das Wärmetauschermittel einen zweiten Wärmetauscher (42"') neben dem ersten Wärmetauscher (41"') umfasst, wobei die andere Seite des thermoelektrischen Kühlungselements (8"') in Wärmeübertragungsverbindung mit einem ersten Ende des zweiten Wärmetauschers (42"') steht.

5. Kühlungsvorrichtung nach einem der Ansprüche 1 bis 4, **dadurch gekennzeichnet, dass** die Kühlungsvorrichtung (100) ein Heizelement (17) umfasst, das dazu eingerichtet ist, die erste Kammer (1) zu heizen, wobei das Heizelement (17) in Wärmeübertragungsverbindung mit einem ersten Ende von mindestens einem Wärmetauscher steht.

6. Kühlungsvorrichtung nach einem der vorhergehenden Ansprüche, **dadurch gekennzeichnet, dass** der mindestens eine Wärmetauscher mindestens einen kompakten Thermosiphon-Wärmetauscher umfasst.

7. Kühlungsvorrichtung nach einem der vorhergehenden Ansprüche, **dadurch gekennzeichnet, dass** die Einlassströmungsöffnung (12) und die Auslassströmungsöffnung (14) auf derselben Seite der ersten Kammer (1) an einer Verbindungswand (102) der Kühlungsvorrichtung (100) angeordnet sind, und die Verbindungswand (102) eine im Wesentlichen planare Wand ist, um die Verbindung der Kühlungsvorrichtung (100) mit der Vorrichtungskammer (202) zu bilden.

8. Gekühlte elektrische Anordnung, umfassend eine Vorrichtungskammer (202), welche eine wärmeerzeugende Vorrichtung (204) enthält, und eine Kühlungsvorrichtung (100), die mit der Vorrichtungskammer (202) verbunden ist, um die wärmeerzeugende Vorrichtung (204) zu kühlen, **dadurch gekennzeichnet, dass** die Kühlungsvorrichtung (100) eine Kühlungsvorrichtung nach einem der Ansprüche 1 bis 7 ist.

9. Gekühlte elektrische Anordnung nach Anspruch 8, **dadurch gekennzeichnet, dass** die Vorrichtungskammer (202) gegenüber Umgebungsluft isoliert ist, so dass die Vorrichtungskammer (202) dazu eingerichtet ist, Kühlmittel ausschließlich mit der ersten Kammer (1) der Kühlungsvorrichtung (100) auszutauschen.

## Revendications

1. Dispositif de refroidissement comprenant:
une première chambre (1);
une seconde chambre (2) séparée de la première chambre (1) et conçue pour être en contact avec l'air ambiant;
des moyens d'échange de chaleur (4) comprenant au moins un échangeur de chaleur, les moyens d'échange de chaleur (4) divisant la première chambre (1) en une section supérieure et une section inférieure, une première extrémité de chacun dudit au moins un échangeur de chaleur étant située dans la première chambre (1), et une seconde extrémité de chacun dudit au moins un échangeur de chaleur étant située dans la seconde chambre (2), les moyens d'échange de chaleur (4) étant conçus pour transférer de la chaleur de la première chambre (1) à la seconde chambre (2); et
des moyens de ventilation;
la première chambre (1) comprend une ouverture d'écoulement d'entrée (12) dans la section supérieure de la première chambre (1) et une ouverture d'écoulement de sortie (14) dans la section inférieure de la première chambre (1), les moyens de ventilation comprennent au moins un premier ventilateur (51) conçu pour générer un premier écoulement de fluide de refroidissement (511) à l'intérieur de la première chambre (1) entre l'ouverture d'écoulement d'entrée (12) et l'ouverture d'écoulement de sortie (14) à travers la première extrémité dudit au moins un échangeur de chaleur, et le dispositif de refroidissement (100) est conçu pour se connecter à une chambre de dispositif (202) contenant un appareil de génération de chaleur (204),
où le dispositif de refroidissement (100) comprend un élément de refroidissement thermoélectrique (8') ayant un côté chaud (82') et un côté froid (84'), l'élément de refroidissement thermoélectrique (8') étant conçu pour condenser l'humidité à partir de la première chambre (1),
**caractérisé en ce que** les moyens d'échange de chaleur (4) comprennent un premier échangeur de chaleur (41), l'un des côtés de l'élément de refroidissement thermoélectrique (8') assurant une connexion de transfert de chaleur avec une première extrémité du premier échangeur de chaleur (41).

2. Dispositif de refroidissement selon la revendication 1, **caractérisé en ce que** le dispositif de refroidissement (100) comprend des moyens de tuyauterie (9) conçus pour transporter de l'eau condensé par l'élément de refroidissement thermoélectrique (8) hors de la première chambre (1).

3. Dispositif de refroidissement selon la revendication 2, **caractérisé en ce que** les moyens de tuyauterie (9) sont conçus pour transporter de l'eau condensée par l'élément de refroidissement thermoélectrique (8) dans la seconde chambre (2) ou hors du dispositif de refroidissement (100).

4. Dispositif de refroidissement selon l'une quelconque des revendications 1 à 3, **caractérisé en ce que** les moyens d'échange de chaleur comprennent un second échangeur de chaleur (42"') adjacent au premier échangeur de chaleur (41"'), l'autre côté de l'élément de refroidissement thermoélectrique (8"') assurant une connexion de transfert de chaleur avec une première extrémité du second échangeur de chaleur (42'").

5. Dispositif de refroidissement selon l'une quelconque des revendications 1 à 4, **caractérisé en ce que** le dispositif de refroidissement (100) comprend un élément chauffant (17) conçu pour chauffer la première chambre (1), l'élément chauffant (17) assurant une connexion de transfert de chaleur avec une première extrémité dudit au moins un échangeur de chaleur.

6. Dispositif de refroidissement selon l'une quelconque des revendications précédentes, **caractérisé en ce que** ledit au moins un échangeur de chaleur comprend à au moins un échangeur de chaleur à thermosiphon compact.

7. Dispositif de refroidissement selon l'une quelconque des revendications précédentes, **caractérisé en ce que** l'ouverture d'écoulement d'entrée (12) et l'ouverture d'écoulement de sortie (14) sont situées du même côté de la première chambre (1) sur une paroi de connexion (102) du dispositif de refroidissement (100) et la paroi de connexion (102) constitue une paroi sensiblement plane pour faciliter la connexion du dispositif de refroidissement (100) à la chambre de l'appareil (202).

8. Ensemble électrique refroidi comprenant une chambre de dispositif (202) contenant un appareil générateur de chaleur (204), et un dispositif de refroidissement (100) relié à la chambre de dispositif (202) pour refroidir l'appareil de génération de chaleur (204), **caractérisé en ce que** le dispositif de refroidissement (100) est un dispositif de refroidissement selon l'une quelconque des revendications 1 à 7.

9. Ensemble électrique refroidi selon la revendication 8, **caractérisé en ce que** la chambre de dispositif (202) est isolée de l'air ambiant de telle sorte que la chambre de dispositif (202) est conçue pour échanger du produit de refroidissement exclusivement avec la première chambre (1) du dispositif de refroidissement (100).
